Europäisches Patentamt

European Patent Office

Office européen des brevets

(19)

(11) Numéro de publication : **0 087 991**
**B1**

(12)

# FASCICULE DE BREVET EUROPÉEN

(45) Date de publication du fascicule du brevet :
**11.02.87**

(51) Int. Cl.⁴ : **H 01 L 41/22**

(21) Numéro de dépôt : **83400272.7**

(22) Date de dépôt : **08.02.83**

(54) Procédé de fabrication de transducteurs polymères piézoélectriques par forgeage.

(30) Priorité : **22.02.82 FR 8202876**

(43) Date de publication de la demande :
**07.09.83 Bulletin 83/36**

(45) Mention de la délivrance du brevet :
**11.02.87 Bulletin 87/07**

(84) Etats contractants désignés :
**DE GB IT NL**

(56) Documents cités :
**EP-A- 0 002 161**
**EP-A- 0 035 425**
**FR-A- 2 151 047**

(73) Titulaire : **THOMSON-CSF**
**173, Boulevard Haussmann**
**F-75379 Paris Cedex 08 (FR)**

(72) Inventeur : **Broussoux, Dominique**
**THOMSON-CSF SCPI 173, bld Haussmann**
**F-75379 Paris Cedex 08 (FR)**
Inventeur : **Facoetti, Hugues**
**THOMSON-CSF SCPI 173, bld Haussmann**
**F-75379 Paris Cedex 08 (FR)**
Inventeur : **Micheron, François**
**THOMSON-CSF SCPI 173, bld Haussmann**
**F-75379 Paris Cedex 08 (FR)**

(74) Mandataire : **Desperrier, Jean-Louis et al**
**THOMSON-CSF SCPI 19, avenue de Messine**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente demande de brevet concerne un procédé de fabrication de transducteurs piézoélectriques à partir d'un matériau polymère.

Pour établir dans une lame en matériau polymère tel que le polyfluorure de vinylidène (PVF$_2$) des propriétés piézoélectriques, il est connu de soumettre cette lame à un étirage important qui vise à convertir une phase solide non polaire en phase solide polaire. Lorsqu'une telle lame a été soumise à un étirage selon l'une de ses dimensions et polarisée par un champ électrique de direction perpendiculaire à l'axe d'étirage, elle présente des propriétés piézoélectriques fortement anisotropes. On a souvent besoin, pour des dispositifs tels que les microphones piézoélectriques à plaques encastrées, de lames possédant une symétrie de révolution de leurs propriétés piézoélectriques. Les lames obtenues par une technique de monoétirage ne sont donc pas les mieux adaptées. On peut chercher à réduire l'anisotropie dans le plan de la lame par biétirage. Cette méthode consiste à étirer une lame d'abord dans une direction, puis à l'étirer à nouveau dans une direction perpendiculaire à la première en faisant en sorte que l'étirage de la lame soit de même importance dans les deux directions. Toutefois, les propriétés piézoélectriques d'une lame biétirée manquent d'uniformité pour des directions comprises entre les deux axes d'étirage, en particulier le module d'YOUNG sera minimum le long des bissectrices des angles formés par les axes d'étirage.

Afin de pallier ces inconvénients, l'invention, telle que la définissent les revendications indépendantes 1 et 2, propose un procédé de fabrication de lames piézoélectriques par écrasement d'une préforme, cet écrasement assurant un allongement uniforme de la préforme dans toutes les directions, à une même distance du centre de la lame et donnant donc la symétrie de révolution désirée.

Cet écrasement peut se faire entre deux plateaux presseurs plats et parallèles, ou entre deux plateaux presseurs ayant la forme de deux portions de sphère respectivement concave et convexe et de même rayon de courbure.

L'invention sera mieux comprise par la description ci-après et les figures l'accompagnant parmi lesquelles :

la figure 1 est une vue isométrique d'une lame de matériau polymère ;

les figures 2 et 3 sont des diagrammes explicatifs ;

la figure 4 représente un dispositif destiné à la mise en œuvre du procédé selon l'invention ;

la figure 5 représente une variante d'un dispositif destiné à la mise en œuvre du procédé selon l'invention ;

les figures 6 et 7 représentent des étapes différentes d'un procédé de fabrication selon l'invention.

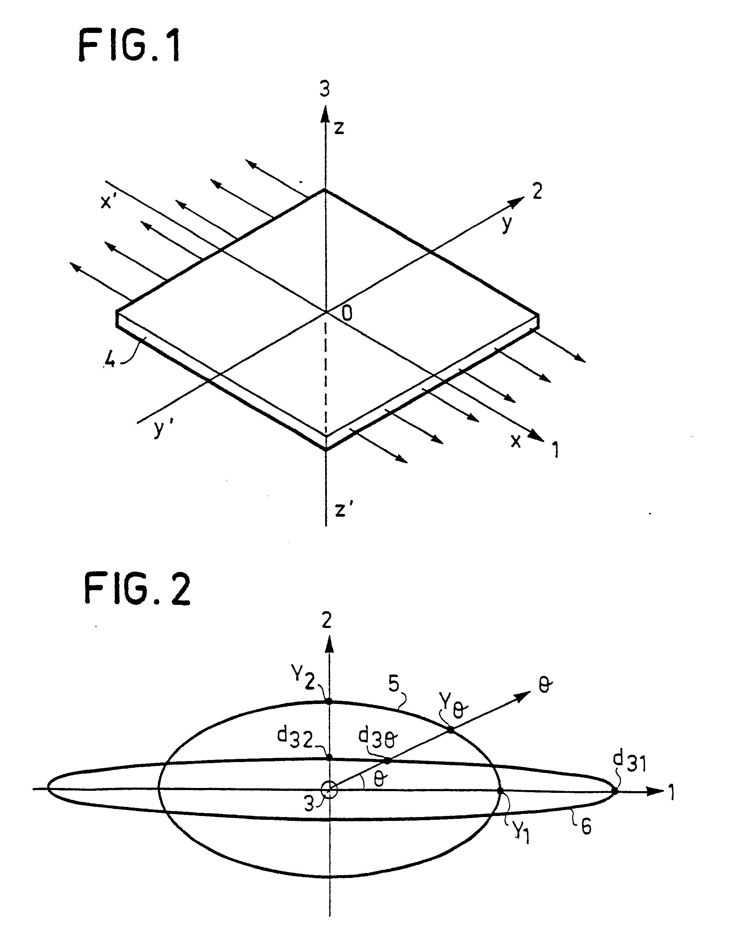

La figure 1 est une vue isométrique d'une lame en matériau polymère susceptible d'acquérir des propriétés piézoélectriques. On peut utiliser par exemple du polyfluorure de vinylidène (PVF$_2$). La structure du PVF$_2$ se compose d'amas cristallins sphéroïdaux contenus dans une phase amorphe et ses propriétés mécaniques macroscopiques sont celles d'un corps isotrope. La lame 4 est constituée de PFV$_2$ en phase $\alpha$ qui est la phase correspondant au produit obtenu à partir du polymère fondu. La lame a été choisie de forme carrée afin de faciliter l'interprétation des phénomènes physiques résultant des opérations qu'elle subira. On a appelé O le centre géométrique de la lame à partir duquel on a représenté un système d'axes orthonomés suivant les directions 1, 2 et 3 (x'x, y'y, z'z) parallèles aux arêtes de la lame. La lame est donc un parallélépipède rectangle. Un moyen classique d'engendrer un effet piézoélectrique dans le polymère consiste à étirer la lame dans une direction, par exemple suivant l'axe x'x comme l'indiquent les flèches, et de lui appliquer, simultanément ou non, un champ électrique dans une direction parallèle à l'axe zz'. L'allongement consécutif à l'étirage de la lame peut atteindre plusieurs fois la longueur initiale de celle-ci. Le système de contraintes mécaniques appliquées provoque une transformation de phase $\alpha$ non polaire, en phase $\beta$ polaire orientée mécaniquement et électriquement. Pour être efficace, l'allongement doit être irréversible et être de 300 à 700 %. Il peut être obtenu à l'aide d'une machine de traction ou par laminage avec fusion et recristallisation. Dans ces deux cas, la direction d'étirement présente un module d'YOUNG supérieur à celui mesuré dans les deux autres directions et les propriétés élastiques et piézoélectriques sont alors fortement anisotropes. Ainsi, le module d'YOUNG $Y_1$ mesuré suivant l'axe d'étirage x'x peut être le double du module $Y_2$ mesuré selon l'axe yy' et le coefficient piézoélectrique $d_{31}$ égal à dix fois $d_{32}$. C'est ce que représente la figure 2 qui est un diagramme projeté sur un plan défini par les directions 1 et 2, la direction 3 étant située orthogonalement à ce plan. La courbe 5 représente la valeur du module d'YOUNG $Y_\theta$ mesuré dans le plan xOy, pour un angle $\theta$ par rapport à la direction d'étirage ; on remarque que $Y_1 = 2 Y_2$. La courbe 6 représente la valeur du coefficient piézoélectrique $d_{3\theta}$ pour direction $\theta$ ; on remarque que $d_{31} = 10 d_{32}$.

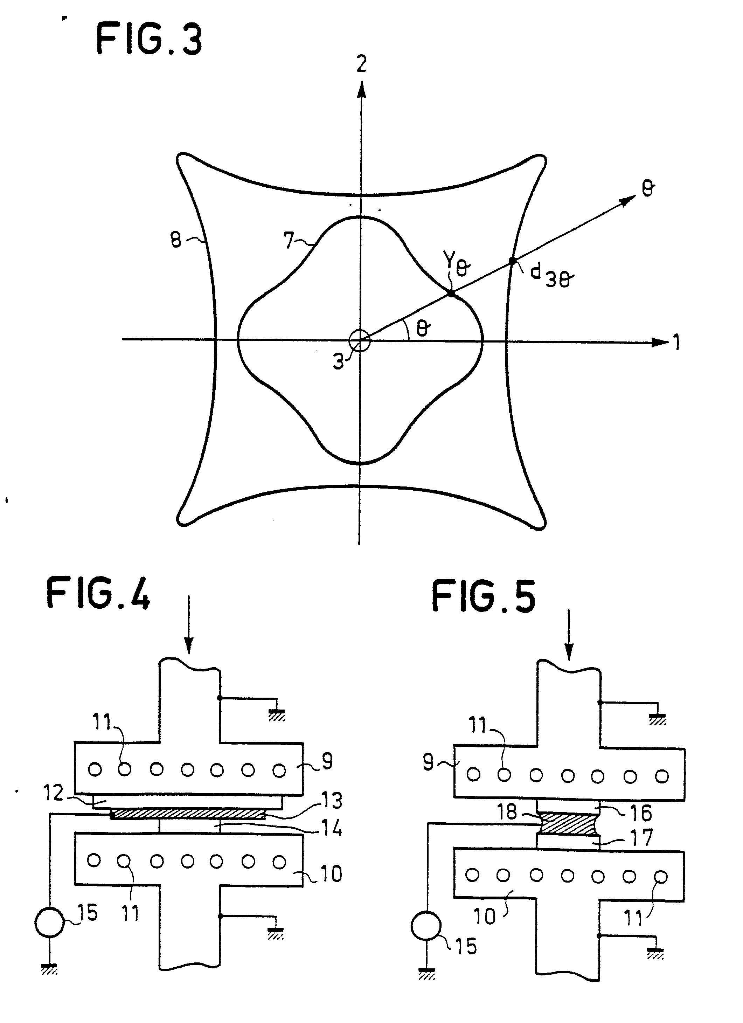

Comme il a été dit plus haut, il est possible de diminuer l'anisotropie dans le plan du film par biétirage. Par exemple, après avoir étiré la lame suivant la direction 1, on peut réaliser un étirage égal suivant la direction 2. Les paramètres mécaniques et piézoélectriques sont alors modifiés comme le montre la figure 3. Ces paramètres sont identiques dans le plan du film selon les deux directions d'étirage. Cependant, ils dépendent de la direction comprise entre ces deux axes du plan et représentée par l'angle $\theta$. On constate que le module d'YOUNG $Y_\theta$ qui décrit la courbe 7, est maximum suivant les axes d'étirement et minimum suivant les bissectrices des angles définis par ces axes. Le coefficient piézoélectrique $d_{3\theta}$ par contre est minimum selon les directions d'étirage et maximum selon les bissectrices des angles définis par ces axes — courbe 8. Ces variations relatives selon les directions du plan sont en général inférieures ou égales à 20 % ce qui est acceptable pour beaucoup d'applications où n'interviennent pas les résonances en modes transverses. Par ailleurs, des éléments découpés au hasard dans un film biétiré ont des comportements semblables pourvu que les marges du film aient été éliminées.

L'inconvénient majeur de la technologie du biétirage est son prix de revient élevé. Par ailleurs, les défauts de symétrie de révolution dans le plan du film privilégient des modes vibratoires par secteurs de dissymétrie, ce qui entraîne des effets de résonance parasites et nuisibles.

La méthode de transformation proposée dans la présente demande de brevet consiste en l'écrasement d'une pièce de polymère entre des plateaux presseurs. Lors de l'écrasement du polymère, l'écartement entre les plateaux est le même pour tous les points situés sur un cercle centré sur l'axe d'écrasement et situé dans un plan parallèle aux plateaux. Le polymère subit un fluage irréversible guidé entre des plans parallèles. Ce fluage forcé ou forgeage est effectué dans une gamme de température et de pressions qui diminue l'épaisseur de la pièce forgée dans un rapport compris entre 5 et 15 ce qui se traduit par une augmentation de surface dans le même rapport.

Lorsque l'on applique ce procédé à un polymère tel que le $PVF_2$, ceci conduit à la transition complète de la phase $\alpha$ non polaire à la phase $\beta$ polaire. Un exemple typique de pièce à forger est constitué par une préforme ressemblant à un disque de diamètre 2,5 cm et d'épaisseur 3 mm. Ce disque est placé entre les plateaux d'une presse qui sont portés à une température de 100 °C. Après équilibrage des températures, une pression de 1,96 GP$_a$ (20 T/cm$^2$) est appliquée pendant 5 mn sur le disque. Ceci correspond à une vitesse initiale de rapprochement des plateaux d'environ 1 mm par minute. A la fin de l'opération, l'épaisseur de l'échantillon obtenu est alors d'environ 400 microns. Une analyse à l'infrarouge révèle que la transformation de la phase $\alpha$ à la phase $\beta$ est complète. L'étude de la morphologie du produit obtenu, par diffusion de la lumière aux petits angles indique que les chaînes moléculaires constituant le polymère sont orientées radialement. La méthode consiste à illuminer une petite zone du polymère par un faisceau de lumière polarisée et à observer la figure de diffusion obtenue en sortie d'analyseur croisé avec la direction de polarisation du faisceau incident. Si le faisceau illumine le centre de l'échantillon, on observe une figure de diffusion en croix caractéristique d'une distribution radiale des directions des chaînes. Si le faisceau illumine une zone située en bordure de l'échantillon, la figure de diffusion est au contraire caractéristique d'une distribution anisotropique des chaînes dont la direction principale suit un rayon de l'échantillon.

On métallise l'échantillon précédemment obtenu sur ses deux faces par évaporation d'aluminium ; ces métallisations sont des couches de 100 nm environ d'épaisseur. L'échantillon métallisé est alors porté à la température de 80 °C et est polarisé sous une tension de 10 kV ce qui correspond à un champ électrique appliqué de 250 kV/cm. Le champ électrique est appliqué pendant 30 mn puis la température est ramenée à la température ambiante au cours d'une période de temps de 30 mn également. Le champ électrique reste appliqué pendant la descente en température. Le coefficient piézoélectrique $d_{33}$ mesuré est d'environ 6 pC $\cdot$ N$^{-1}$, valeur relativement faible explicable par la faible valeur du champ électrique appliqué.

La polarisation à saturation ($P = 6 \cdot 10^{-2}$ C $\cdot$ m$^{-2}$) aurait été obtenue pour un champ électrique de 1,5 MV/cm pour les mêmes contraintes exercées sur le précédent échantillon ; le coefficient piézoélectrique $d_{33}$ aurait atteint dans ces conditions environ 25 pC $\cdot$ N$^{-1}$ ce qui implique une tension de polarisation de l'ordre de 60 kV difficile à appliquer pratiquement pour des raisons de claquage par contournement. Aussi est-il préférable dans le procédé de fabrication d'associer le forgeage à une polarisation électrique au cours de la déformation du polymère. En effet, des champs électriques relativement faibles (environ 500 kV/cm) appliqués au cours de la transition de la phase $\alpha$ à la phase $\beta$ pour un polymère $PVF_2$ contribuent à l'obtention de la phase $\beta$ orientée électriquement. Cet effet s'explique par le fait que la transition s'accompagne d'une fusion du polymère en phase $\alpha$ suivie d'une recristallisation en phase $\beta$ dans le double champ des contraintes mécaniques et électriques. Cette technique appliquée au cas du $PVF_2$ s'est avérée particulièrement efficace puisque des coefficients $d_{33}$ de l'ordre de 20 à 22 pC $\cdot$ N$^{-1}$ ont été obtenus, indiquant l'approche de la saturation de la polarisation.

Une façon de procéder est illustrée par la figure 4 qui représente un dispositif destiné à la mise en œuvre du procédé de fabrication d'une galette piézoélectrique selon l'invention. Sur cette figure, on peut voir deux plateaux presseurs plats et parallèles 9 et 10 reliés à la masse et capables de chauffer une préforme par le passage d'un courant électrique dans des résistances chauffantes 11. Une préforme polymère 14, en forme de disque, par exemple en $PVF_2$ est placée entre les plateaux presseurs. Avant le pressage on intercale, par exemple entre le plateau supérieur 9 et le disque 14 un diélectrique 12. Ce diélectrique est par exemple une plaque de verre époxy. Il est recouvert d'une métallisation 13 en contact avec le polymère 14.

Cette métallisation peut consister en une couche de cuivre. Ce diélectrique présentant une face cuivrée est donc du type utilisé pour la gravure de circuits imprimés. La couche métallique 13 est reliée à un pôle d'une source de haute tension 15 dont l'autre pôle est relié à la masse. Les conditions de température et de pressage sont les mêmes que précédemment et une tension V = 5 kV est appliquée. Avec cette méthode, la tension applicable entre la métallisation 13 et le plateau inférieur de la presse est de 30 kV par centimètre de couche d'air sinon on court le risque de produire des amorçages dans la couche d'air comprise entre le plateau inférieur et la partie non masquée de l'électrode 13 au cours du pressage. Cette tension s'avère insuffisante pour polariser le polymère à saturation. Toutefois, l'écrasement du polymère étant réalisé, la couche d'air comprise entre l'électrode 13 et le plateau 10 peut se combler du fait de l'augmentation de surface du disque de polymère. Celui-ci peut alors occuper toute la surface de l'électrode 13 et l'on peut alors augmenter la tension de polarisation à des valeurs supérieures à la tension d'amorçage d'une couche d'air d'égale épaisseur.

Cette façon de procéder revient en partie au cas de la polarisation après déformation qui est moins efficace que la méthode consistant à déformer et à polariser simultanément un polymère. Une solution meilleure consiste à disposer d'une électrode de polarisation susceptible de fluer en même temps que le disque de polymère et dans le même rapport. Il est particulièrement avantageux dans ce cas de fabriquer deux galettes piézoélectriques au cours de la même opération en intercalant l'électrode de polarisation entre les deux préformes de polymère à travailler. Cette méthode est représentée par la figure 5 où l'on voit un dispositif de pressage et de polarisation électrique simultanés.

Sur cette figure on distingue la même machine de pressage que celle représentée à la figure 4 et constituée principalement de deux plateaux presseurs plats et parallèles 9 et 10 ayant des faces rigides conductrices mises au potentiel de la masse. Ces plateaux sont chauffés par un dispositif de résistances chauffantes 11. Les préformes de polymère à travailler 16 et 17 se présentent par exemple sous forme de disques et ont chacune l'une de leurs faces en contact avec l'un des plateaux. Elles sont séparées par une électrode 18 susceptible de fluer sous l'effet de la pression exercée par les plateaux 9 et 10. L'électrode 18 est réalisée en polymère rendu conducteur par l'incorporation de particules conductrices. Ces particules peuvent être du noir de carbone conducteur représentant environ 20 % du volume de l'électrode. Un générateur de tension continue 15 est branché entre l'électrode 18 et les plateaux. En choisissant pour l'électrode 18 un polymère qui se déforme de manière identique aux cylindres à forger on évitera les court-circuits possibles entre cette électrode et l'un des plateaux, de même qu'un retrait de l'électrode de polarisation par rapport aux échantillons, lors du pressage. Une solution simple consiste à choisir le polymère constituant l'électrode de même nature que celui des cylindres, par exemple en $PVF_2$. Dans les

mêmes conditions opératoires que précédemment et pour une tension appliquée de 25 kV durant toute l'opération, on obtient un coefficient piézoélectrique d'environ 22 pC · $N^{-1}$ homogène dans le plan des deux galettes piézoélectriques obtenues. L'analyse du taux d'alignement dipolaire en phase révèle que celui-ci atteint 85 % soit une valeur proche de la saturation.

Ce procédé de transformation du polymère $PVF_2$ en phase β se prête particulièrement bien à l'obtention rapide et économique de plaques circulaires à distribution radiale des chaînes, utilisables dans les transducteurs à symétrie de révolution tels que les microphones piézoélectriques à plaques encastrées décrits dans la demande de brevet de la demanderesse EP-A-0 072 288. Il permet aussi la production de bimorphes à symétrie radiale ; l'électrode intermédiaire déformable est alors obtenue selon le procédé décrit dans la demande de brevet de la demanderesse EP-A-0 086 922 et qui permet à la fois le collage de deux lames polymères entre elles et leur polarisation simultanée.

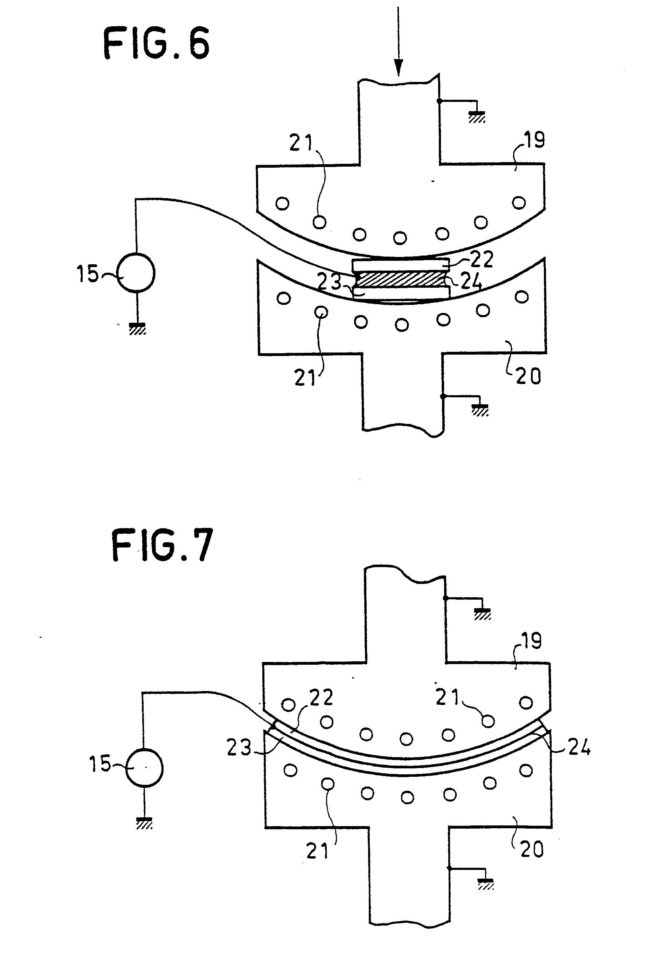

Ce procédé peut être étendu à l'obtention de formes non planes, telles que des calottes sphériques ou des surfaces cannelées, imposées par deux moules complémentaires, l'un en relief et l'autre en creux. Dans ce cas, il est possible de partir de disques. Les figures 6 et 7 représentent des étapes différentes du procédé de fabrication. La figure 6 représente la phase initiale du procédé. Les disques de polymère 22 et 23 sont plans, leurs axes de révolution sont confondus avec l'axe d'écrasement et ils sont séparés par l'électrode intermédiaire 24 qui est reliée à une borne du générateur de tension continue 15. L'autre borne du générateur est au même potentiel que les plateaux 19 et 20. Ceux-ci ont la forme de portions de sphères respectivement convexe et concave et de même rayon de courbure et sont destinés à fournir dans l'exemple des figures 6 et 7 des objets en forme de calottes sphériques. Lorsque les plateaux se rapprochent, les centres des portions de sphères restent sur l'axe d'écrasement. Comme précédemment ces plateaux peuvent être chauffés par des résistances chauffantes 21. Le pressage de l'empilement réalisé par les cylindres 22 et 23 et l'électrode 24, qu'il est avantageux de choisir en forme de disque, et la polarisation simultanée, assurés dans des conditions comparables à celles des précédentes réalisations, permettent d'obtenir des produits en forme de calotte tels que ceux représentés à la figure 7.

Il entre également dans le cadre de l'invention de réaliser des transducteurs piézoélectriques à partir d'un empilement de plus de deux préformes de polymère séparées par des électrodes de polarisation. Ces électrodes peuvent ou non assurer le collage entre deux galettes suivant les besoins. Il convient alors de faire en sorte que la température à laquelle sont portés les disques de polymère soit uniforme dans tous les niveaux de l'empilement.

L'invention s'applique particulièrement bien aux polymères polaires tels que le polyfluorure de vinylidène (PVF$_2$), ses copolymères avec le polytétrafluorure d'éthylène (PTFE), le polytrifluorure d'éthylène (PTrFE) et les alliages avec le polyméthacrylate de méthyle (PMMA). Elle permet aussi la fabrication de transducteurs polymères bimorphes. Elle permet d'obtenir des dispositifs ayant une forme plane ou incurvée.

Afin d'assurer à ces polymères piézoélectriques la stabilité dimensionnelle dans le temps et pour des températures plus élevées que celles auxquelles ils ont été élaborés, ainsi que pour garantir un comportement stable de l'activité piézoélectrique, ils peuvent être recuits sous presse, à une température comprise entre 100 et 110 ºC et pendant une durée variable de 20 mn à 1 heure. Le retrait subséquent est de l'ordre de quelques pour cent et l'activité piézoélectrique baisse de 10 à 30 %, mais la stabilité est alors assurée jusqu'à une température de fonctionnement voisine de celle de recuit.

L'invention concerne tous les domaines d'application de la piézoélectricité et de la pyroélectricité, en particulier les dispositifs électro-acoustiques et les transducteurs bimorphes.

**Revendications**

1. Procédé de fabrication d'une galette en matériau polymère piézoélectrique ayant par rapport à un axe de symétrie perpendiculaire à cette galette des propriétés piézoélectriques uniformes lorsqu'elles sont mesurées par rapport à cet axe, ladite galette étant obtenue à partir d'au moins une préforme par augmentation de ses dimensions transversales et par polarisation électrique à l'aide d'un champ dirigé perpendiculairement à ses faces, caractérisé en ce que l'allongement résulte de l'écrasement de ladite préforme entre deux plateaux presseurs (9, 10) dont les faces en regard, rigides, planes et parallèles, se rapprochent suivant la direction qui leur est normale, et en ce que la préforme (14) a l'aspect d'un disque dont l'axe est également normale auxdites faces en regard des plateaux presseurs et formera ledit axe de symétrie de la galette en fin d'écrasement.

2. Procédé de fabrication d'une galette en matériau polymère piézoélectrique ayant par rapport à un axe de symétrie perpendiculaire à cette galette des propriétés piézoélectriques uniformes lorsqu'elles sont mesurées par rapport à cet axe, ladite galette étant obtenue à partir d'au moins une préforme par augmentation de ses dimensions transversales et par polarisation électrique à l'aide d'un champ dirigé perpendiculairement à ses faces, caractérisé en ce que l'allongement résulte de l'écrasement de ladite préforme entre deux plateaux presseurs (19, 20) dont les faces en regard rigides sont des portions de sphère respectivement convexe (19) et concave (20) se rapprochant selon un axe normal au centre des faces avec les centres des portions de sphère restant sur cet axe normal, que la préforme a l'aspect d'un disque dont l'axe est confondu avec ledit axe normal et formera ledit axe de symétrie de la galette à la fin de l'écrasement, et que les rayons de courbure des plateaux (19, 20) sont déterminés de façon telle que la galette obtenue ait la forme d'une calotte sphérique.

3. Procédé de fabrication selon l'une quelconque des revendications 1 et 2, caractérisé en ce que l'écrasement est réalisé à chaud.

4. Procédé de fabrication selon l'une quelconque des revendications 1 à 3, caractérisé en ce que l'écrasement et la polarisation électrique sont réalisés simultanément.

5. Procédé de fabrication selon la revendication 4, caractérisé en ce que la polarisation est appliquée à la préforme par l'intermédiaire d'au moins une électrode de polarisation (13) et est susceptible de fluer au cours de l'écrasement en gardant ses propriétés électriques.

6. Procédé selon la revendication 5, caractérisé en ce que l'on réalise simultanément au moins deux galettes polymères piézoélectriques en empilant au moins deux préformes (16, 17) séparées par une électrode de polarisation (18).

7. Procédé selon la revendication 6, caractérisé en ce que l'électrode de polarisation (18) est susceptible de se coller aux deux galettes pendant l'écrasement pour former avec celles-ci un transducteur bimorphe dont l'électrode de polarisation forme l'électrode intermédiaire.

**Claims**

1. A method for fabricating a wafer of piezoelectric polymeric material which has uniform piezoelectric properties with respect to an axis of symmetry perpendicular to said wafer when these properties are measured with respect to said axis, said wafer being obtained from at least one preform by stretching its transverse dimension and by an electric polarisation by means of a field directed at right angles to its faces, characterized in that the stretching results from a compression of said preform between two pressure plates (9, 10) having rigid, plane and parallel faces which are approached along a direction perpendicular to their faces, and that the preform is disk-shaped, its axis being also perpendicular to the faces of said pressure plates and constituting the wafer symmetry axis at the end of the stretching phase.

2. A method for fabricating a wafer of piezoelectric polymeric material which has uniform piezoelectric properties with respect to an axis of symmetry perpendicular to said wafer when these properties are measured with respect to said axis, said wafer being obtained from at least one preform by stretching its transverse dimensions and by an electric polarisation by means of a field directed at right angles to its faces, characterized in that the stretching results from a compression of said preform between two pressure plates (19, 20) having rigid faces, which are constituted by convex (19) and concave sphere portions (20) respectively which are approached along a direction which is perpendicular to the center of the faces, the centers of the sphere portions remaining on this perpendicular axis, that the preform is disk-shaped, its axis coinciding with said perpendicular axis and constituting the wafer symmetry axis at the end of the stretching phase, and that the radii of incurvation of the plates (19, 20) are determined in such a way that the final wafer is shaped like a portion of a sphere.

3. A fabrication method according to any one of claims 1 and 2, characterized in that the stretching is obtained at high temperature.

4. A fabrication method according to any one of claims 1 to 3, characterized in that the stretching and the electric polarisation are performed stimultaneously.

5. A fabrication method according to claim 4, characterized in that the polarisation is applied to the preform through at least one polarisation electrode (13) and is capable of undergoing creep deformation during the stretching while retaining its electrical properties.

6. A method according to claim 5, characterized in that at least two piezoelectric polymer wafers are realised simultaneously by stacking at least two preforms (16, 17) wich are separated by a polarisation electrode (18).

7. A method according to claim 6, characterized in that the polarisation electrode (18) is capable of being annealed to the two wafers during the stretching phase in order to constitute together with these wafers a bimorphous transducer, the polarisation electrode of which constitutes the intermediate electrode.

**Patentansprüche**

1. Verfahren zur Herstellung einer Scheibe as einem piezoelektrischen Polymer, die bezüglich einer zu diese Scheibe senkrechten Symmetrieachse gleichförmige piezoelektrische Eigenschaften besitzt, wenn diese bezüglich dieser Achse gemessen werden, wobei die Scheibe ausgehend von mindestens einem Rohling durch Erhöhung von dessen Querabmessungen und durch elektrische Polarisation mithilfe eines senkrecht auf seine Oberseiten ausgerichteten elektrischen Felds erhalten wird, dadurch gekennzeichnet, daß die Streckung aus der Verformung des Rohlings zwischen zwei Preßplatten (9, 10) resultiert, deren einander gegenüberliegende starre und parallele Flächen einander gemäß ihrer Normalen angenähert werden, und daß der Rohling (14) eine Scheibe ist, deren Achse ebenfalls senkrecht zu den einander gegenüberliegenden Seiten der Druckplatten liegt und die Symmetrieachse der Scheibe nach der Verformung bilden wird.

2. Verfahren zur Herstellung einer Scheibe aus einem piezoelektrischen Polymer, die bezüglich einer zu dieser Scheibe senkrechten Symmetrieachse gleichförmige piezoelektrische Eigenschaften besitzt, wenn diese bezüglich dieser Achse gemessen werden, wobei die Scheibe ausgehend von mindestens einem Rohling durch Erhöhung von dessen Querabmessungen und durch elektrische Polarisation mithilfe eines senkrecht auf seine Oberseiten ausgericheten elektrischen Felds erhalten wird, dadurch gekennzeichnet, daß die Streckung aus der Verformung des Rohlings zwischen zwei Preßplatten (19, 20) resultiert, deren einander gegenüberliegende starre Flächen konvexe (19) bzw. konkave Kugelflächenabschnitte (20) sind, die sich in Richtung einer zum Zentrum dieser Flächen Normalen-Achse einander annäher, wobei die Zentren der Kugelflächenabschnitte auf dieser Normalen-Achse bleiben, und daß der Rohling eine Scheibe ist, deren Achse mit der Normalen-Achse zusammenfällt und die Symmetrieachse der Scheibe nach der Verformung bilden wird, und daß die Krümmungsradien der Platten (19, 20) so festgelegt werden, daß die erhaltene Scheibe die Form einer Kugelkalotte annimmt.

3. Herstellungsverfahren nach einem beliebigen der Ansprüche 1 und 2, dadurch gekennzeichnet, daß die Verformung unter Wärmeeinwirkung erfolgt.

4. Herstellungsverfahren nach einem beliebigen der Ansprüche 1 bis 3, dadurch gekennzeichnet, daß die Verformung und die elektrische Polarisation gleichzeitig durchgeführt werden.

5. Herstellungsverfahren nach Anspruch 4, dadurch gekennzeichnet, daß die Polarisation an den Rohling über mindestens eine Polarisationselektrode (13) angelegt wird und im Laufe der Verformung zerdrückt werden kann, ohne ihre elektrischen Eigenschaften zu verlieren.

6. Verfahren nach Anspruch 5, dadurch gekennzeichnet, daß mindestens zwei piezoelektrische Polymerscheiben hergestellt werden, indem mindestens zwei Rohlinge (16, 17) getrennt durch eine Polarisationselektrode (8) übereinandergestapelt werden.

7. Verfahren nach Anspruch 6, dadurch gekennzeichnet, daß die Polarisationselektrode (18) während der Verformung an den beiden Scheiben ankleben kann, um mit ihnen einen bimorphen Transduktor zu bilden, dessen Polarisationselektrode die Zwischenelektrode bildet.

# FIG.1

# FIG.2

# FIG.3

# FIG.4

# FIG.5

# FIG.6

# FIG.7